Europäisches Patentamt

European Patent Office

Office européen des brevets

(19)

(11) Numéro de publication : **0 150 140**
**B1**

(12) **FASCICULE DE BREVET EUROPÉEN**

(45) Date de publication du fascicule du brevet :
02.03.88

(21) Numéro de dépôt : 85400028.8

(22) Date de dépôt : 08.01.85

(51) Int. Cl.⁴ : **H 03 F   3/193,** H 03 F   1/30,
H 03 F   3/60

(54) Circuit de polarisation d'un transistor à effet de champ.

(30) Priorité : 20.01.84 FR 8400889

(43) Date de publication de la demande :
31.07.85 Bulletin 85/31

(45) Mention de la délivrance du brevet :
02.03.88 Bulletin 88/09

(84) Etats contractants désignés :
DE GB IT NL

(56) Documents cités :
EP-A- 0 048 885
WO-A-80 /015 27
DE-A- 2 010 329
GB-A- 2 057 803
US-A- 3 801 933
TELECOMMUNICATIONS & RADIO ENGINEERING,
vol. 29/30, no. 8, août 1975, pages 98-101, Washington,
US; V.N. SHLYCHKOV: "Operating-point stabilization
in a series-fed amplifier stage comprising field-effect
and bipolar transistors"

(73) Titulaire : **THOMSON-CSF**
**173, Boulevard Haussmann**
**F-75379 Paris Cédex 08 (FR)**

(72) Inventeur : **Rumelhard, Christian**
**THOMSON-CSF SCPI 173, bld Haussmann**
**F-75379 Paris Cedex 08 (FR)**

(74) Mandataire : **Taboureau, James**
**THOMSON-CSF SCPI 19, avenue de Messine**
**F-75008 Paris (FR)**

EP 0 150 140 B1

## Description

La présente invention concerne un circuit de polarisation d'un transistor à effet de champ, fonctionnant en régime hyperfréquences. Ce circuit de polarisation permet de faire varier simultanément les tensions de polarisation sur deux électrodes du transistor, dont la grille. Il est particulièrement intéressant dans le cas où il est lui-même intégré sur un circuit intégré monolithique comportant d'autres fonctions, car il occupe une surface de pastille sur le matériau semiconducteur beaucoup plus petite que les circuits connus.

Pour ne pas perturber les signaux micro-onde — ou hyperfréquences — les circuits de polarisation doivent être filtrés, par des moyens qui laissent passer les tensions ou courants continus de polarisation mais isolent la puissance micro-onde. Ces moyens sont le plus fréquemment des selfs, des lignes microbandes ou des résistances de forte valeur. Les deux premiers ont l'inconvénient de ne pas être de dimensions et de technologie compatibles avec les circuits intégrés. Les résistances ont l'inconvénient que, si un courant drain est nécessaire, la chute de tension à travers la résistance est importante, et la tension de polarisation doit être élevée.

Dans d'autres circuits connus (voir DE-A-20 10 329), la polarisation de drain du transistor à effet de champ principal est assurée par un transistor à effet de champ secondaire, monté en source de courant, grille reliée à la source : mais la tension de polarisation du drain est fixe dans ce cas et il n'est pas possible de faire varier la tension de polarisation de grille, donc le point de polarisation du transistor principal.

Dans le circuit de polarisation selon l'invention, la polarisation du drain (ou de la source selon le schéma utilisé) du transistor à effet de champ principal, est assurée par au moins un premier transistor secondaire, fonctionnant en charge saturable, dont la tension grille-source suit la tension grille-source du transistor à effet de champ principal grâce à un pont de résistances alimenté par un second transistor à effet de champ secondaire monté en source de courant.

De façon plus précise l'invention concerne un circuit de polarisation d'un transistor à effet de champ, fonctionnant dans le domaine des hyperfréquences, dont la grille est polarisée par une tension à travers une première résistance, ce circuit étant caractérisé en ce que au moins une électrode d'accès du transistor principal, par laquelle sort le signal hyperfréquence, est polarisée, à partir d'une source de tension, à travers un premier transistor secondaire, à effet de champ, fonctionnant en charge saturable, dont la tension grille-source suit la tension grille-source du transistor principal, les grilles de ces deux transistors étant réunies en deux points (B et A respectivement) d'un point diviseur constitué par au moins deux résistances, alimenté à partir des deux tensions de polarisation à travers un second transistor secondaire monté en source de courant.

L'invention sera mieux comprise par la description détaillée qui suit de quelques exemples de polarisation, le transistor principal étant monté en source commune ou en drain commun ou en grille commune. Ces descriptions s'appuient sur les figures suivantes qui représentent :

figure 1 : schéma de base de la polarisation d'un transistor à effet de champ,

figures 2 à 5 : schémas pratiques de polarisation d'un transistor à effet de champ selon l'art connu,

figure 6 : circuit de polarisation d'un transistor à effet de champ selon l'invention (source commune),

figure 7 : circuit de polarisation d'un transistor à effet de champ selon l'invention, dans une première variante,

figure 8 : circuit de polarisation d'un transistor à effet de champ selon l'invention (drain commun),

figure 9 : circuit de polarisation d'un transistor à effet de champ selon l'invention (grille commune).

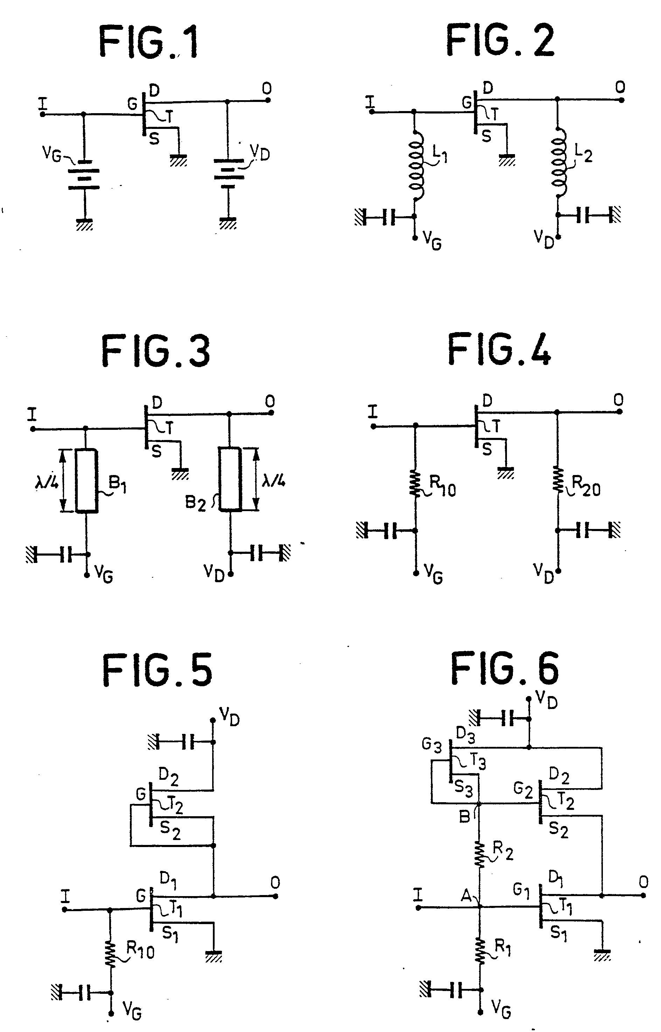

Pour fonctionner correctement, un transistor à effet de champ, travaillant dans le domaine des hyperfréquences ou micro-onde, doit être polarisé par une tension continue sur le drain et une tension continue sur la grille, comme indiquées en figure 1 qui représentent le schéma de base de polarisation d'un transistor à effet de champ monté en source commune.

Soit T ce transistor à effet de champ, dont la source est branchée à la masse ; les signaux hyperfréquences sont introduits sur la grille du transistor au point d'introduction I et ils sortent du dispositif sur le drain en un point repéré O. Pour fonctionner correctement, il est donc nécessaire qu'une tension $V_D$ soit appliquée sur le drain et une tension $V_G$ soit appliquée sur la grille, ces deux tensions étant représentées sur la figure 1 par le schéma symbolique d'un générateur de tension.

Mais, dans certains circuits, la tension de grille $V_G$ doit pouvoir être variée de manière à pouvoir choisir le point de fonctionnement du transistor, par exemple pour qu'un amplificateur fonctionne en classe A ou en classe B ou en classe C. Ou bien pour pouvoir choisir un point de fonctionnement correspondant à un bruit minimum, dans le cas des amplificateurs. Ou encore pour pouvoir varier une phase dans le cas des déphaseurs.

Pour que les circuits de polarisation ne perturbent pas le fonctionnement du circuit micro-onde, les tensions de polarisation sont appliquées sur la grille et le drain à travers des circuits de filtrage qui laissent passer les tensions au courant continu, mais isolent la puissance hyperfréquence. Trois exemples de tels circuits sont représentés dans les figures 2, 3 et 4.

En figure 2 les tensions de grille $V_G$ et de drain

$V_D$ sont appliquées respectivement sur la grille et le drain du transistor T à travers des selfs de choc $L_1$ et $L_2$. Les tensions $V_G$ et $V_D$ sont par ailleurs filtrées par un petit condensateur monté en parallèle et réuni à la masse. Cette méthode de polarisation est tout à fait valable dans le cas des circuits hybrides par exemple ou des transistors à effet de champ montés en discret, car elle permet de varier indépendamment la tension de grille $V_G$ et la tension de drain $V_D$. Mais pour un circuit intégré monolithique, qui comporte un nombre élevé de transistors tel que le transistor T, les selfs de choc qui sont réalisées dans la réalité par des dépôts d'or qui permettent de faire la jonction entre le plot métallique qui amène la tension de polarisation et le plot métallique de la grille ou de drain, ne sont pas compatibles en technologie avec la réalisation de circuits intégrés en raison de leurs dimensions prohibitives.

En figure 3, le transistor T est polarisé sur sa grille et sur son drain par deux lignes microbandes repérées $B_1$ sur la grille et $B_2$ sur le drain. C'est sur ces deux lignes microbandes $B_1$ et $B_2$ que sont appliquées respectivement les tensions de polarisation· de grille $V_G$ et de polarisation de drain $V_D$ : les lignes microbandes ont une impédance caractéristique élevée et une longueur égale à un quart d'onde $\lambda/4$ à la fréquence de fonctionnement du transistor. Cette méthode de polarisation est bien connue, elle est fiable mais de même que la polarisation à travers les selfs de choc, sa technologie n'est pas compatible avec la technologie de fabrication de circuits intégrés. Alors que les dimensions d'un transistor à effet de champ fonctionnant dans le domaine des hyperfréquences se comptent en microns, les dimensions d'une microbande $\lambda/4$ dans les mêmes fréquences, entre 10 et 50 GHz par exemple, se comptent plutôt en mm donc il y a un rapport de dimensions entre transistors et lignes microbandes qui est de l'ordre de $10^3$. Sur la figure 4, les tensions de polarisation sont appliquées à travers des résistances de valeurs suffisamment élevées pour ne pas perturber le fonctionnement du circuit micro-onde. C'est-à-dire que ces résistances laissent passer un courant continu de polarisation, mais présentent une valeur infinie au passage d'un signal hyperfréquence. L'utilisation de résistances de polarisation est plus compatible en technologie que l'utilisation de selfs ou de lignes microbandes, car on sait réaliser des résistances de valeurs élevées et n'occupant qu'une très petite surface sur la pastille d'un circuit intégré. Cependant, ce montage avec des résistances ne convient pour la grille que tant qu'elle n'est pas polarisée positivement, car le courant continu de grille est très faible et aucune chute de tension n'apparaît dans la résistance $R_{10}$ connectée sur la grille. Par contre, en ce qui concerne le drain, la résistance $R_{20}$ doit être suffisamment grande pour ne pas perturber le circuit hyperfréquence mais, simultanément, doit laisser passer un courant drain, par exemple 250 milli-ampères par millimètre de largeur de grille, ce qui aboutit à des chutes de tension extrêmement importantes.

Et par voie de conséquence, à des tensions de polarisation $V_D$, appliquées sur la résistance $R_{20}$, extrêmement importantes, et en dehors du domaine des tensions habituellement utilisées sur les circuits intégrés.

Pour pallier cet inconvénient, le montage de la figure 5 (voir DE-A-20 10 329) est parfois utilisé. Dans ce circuit de polarisation d'un transistor $T_1$, la polarisation de grille est assurée par une tension $V_G$, découplée à la masse, à travers une résistance $R_{10}$, comme en figure 4. Par contre, le drain du transistor $T_1$, qu'on conviendra par la suite d'appeler le transistor principal, c'est-à-dire celui qu'on veut polariser, est polarisé par une tension $V_D$ à travers un transistor secondaire $T_2$ monté en source de courant c'est-à-dire dont la grille est connectée à la source, ce qui assure le passage d'un courant continu important tout en présentant en hyperfréquence une impédance dynamique élevée due à la saturation du courant. C'est pour cette raison que le transistor secondaire $T_2$ est appelé charge saturable car il est bien connu que lorsque l'on dresse les courbes de courant de drain en fonction de la tension de drain d'un transistor à effet de champ, ces courbes présentent rapidement une saturation.

Ce circuit de polarisation introduit quelques pertes supplémentaires, ce qui fait que dans certains cas on monte en série deux transistors charge saturable tels que $T_2$ pour polariser le drain du transistor $T_1$. Cependant, ce circuit permet de gagner une surface importante sur la pastille de matériaux semiconducteurs par rapport aux selfs de choc ou aux lignes microbandes, et c'est un montage qui convient spécialement pour les circuits intégrés puisque dans ce cas, la ou les charges(s) saturable(s) $T_2$ sont de petites surfaces par rapport au transistor principal $T_1$. En effet les charges saturables sont calculées pour être optimisées et fournir juste le courant nécessaire à la polarisation du transistor $T_1$ qui lui, a une surface en fonction de la puissance qu'il doit véhiculer. Ajouter sur un circuit intégré, une ou plusieurs petite(s) charge(s) saturable(s) ne pose(nt) pas de gros problèmes de technologie comme ce serait le cas avec les selfs ou les lignes microbandes.

Cependant, le circuit de la figure 5 a un inconvénient : le point de polarisation du transistor principal $T_1$ est imposé une fois pour toute par la largeur du transistor $T_2$, qui doit être inférieure ou égale à celle de $T_1$. Ce type de circuit exclut donc de faire varier la tension de polarisation de grille $V_G$, donc le point de polarisation du transistor principal $T_1$. Or, il a été dit que dans certains cas d'amplificateur ou de déphaseur par exemple il est intéressant de pouvoir faire varier le point de polarisation d'un transistor.

Le circuit de polarisation selon l'invention est représenté en figure 6. Selon cette figure, le transistor principal $T_1$ que l'on veut polariser convenablement, voit sa grille polarisée par une tension $V_G$ appliquée à travers une résistance $R_1$. Cette tension de polarisation bien entendu est comme dans le cas de toutes les figures décou-

plée à la masse par un condensateur.

La polarisation du drain $D_1$ est assurée à partir d'une tension de polarisation $V_D$ par au moins une charge saturable $T_2$, dont la tension grille-source $V_{G2S2}$ suit la tension grille-source $V_{G1S1}$ du transistor principal $T_1$. Ceci est obtenu par un pont de résistances $R_1$ et $R_2$, $R_1$ étant la résistance de polarisation de la grille $G_1$ du transistor $T_1$, ce pont de résistances $R_1$ et $R_2$ étant lui-même alimenté par un petit transistor $T_3$ monté en source de courant, dont la grille et la source sont reliées, le transistor $T_3$ étant lui-même relié à la source de tension de drain $V_D$. La grille du transistor principal $T_1$ est donc reliée au point A, qui est le point commun aux deux résistances $R_1$ et $R_2$ du pont de résistance, tandis que la grille du transistor charge saturable $T_2$ est reliée au point B, qui se trouve donc être le point d'alimentation du pont diviseur par le petit transistor $T_3$.

Le circuit selon l'invention réunit donc les avantages suivants :

la tension de polarisation de grille $G_1$ du transistor principal $T_1$ est appliquée à travers une résistance $R_1$ de technologie compatible avec celle des circuits intégrés,

la tension de polarisation du drain $D_1$ est appliquée, à partir de la tension $V_D$, à travers un second transistor $T_2$ monté en charge saturable,

mais la tension de grille $G_2$ du transistor $G_2$ suit la tension de grille $G_1$ du transistor $G_1$ grâce à un pont diviseur monté entre les deux sources de tension $V_D$ et $V_G$, muni d'un petit transistor $T_3$ fonctionnant en source de courant, la grille $G_1$ étant réunie au point A du pont diviseur tandis que la grille $G_2$ est réunie au point B de ce même pont diviseur.

Prenons un exemple. Si $V_D = 6$ V, $V_G = -3$ V, $R_1 = R_2 = 1\,000$ Ohms, et le courant de saturation du petit transistor $T_3$ est 3 mA on a alors $V_A = V_{G1} = 0$ V et $V_B = V_{G2} = 3$ V. Si par ailleurs les largeurs des transistors principal $T_1$ et secondaire $T_2$ sont identiques, $V_{D1} = 3$ V. Dans ces conditions, les tensions grille-source $V_{G1S1}$ et $V_{G2S2}$ sont toutes deux égales à 0 V. Si la tension de polarisation de grille varie, par exemple $V_G = -5$ V, en tenant compte du fait que le courant de saturation du transistor $T_3$ ne change pas, les nouvelles tensions grille-source $V_{G1S1}$ et $V_{G2S2}$ sont toujours identiques mais égales à $-2$ V.

Dans le cas où les résistances $R_1$ et $R_2$ du pont ne seraient pas tout à fait égales à la valeur prévue, mais identiques entre elles, il suffirait de faire varier la tension de polarisation de drain $V_D$ pour retrouver l'égalité des valeurs $V_{G1S1} = V_{G2S2}$.

De même, si le courant de saturation du transistor secondaire $T_2$ n'est pas tout à fait égal à la valeur prévue, une variation de la tension de polarisation de drain $V_D$ permet encore de retrouver l'égalité $V_{G1S1} = V_{G2S2}$.

En ce qui concerne les hyperfréquences, qui sont introduites dans le transistor par le point I et en ressortent par le point O, le circuit hyperfréquence extérieur au transistor $T_1$ ne « voit » que la résistance $R_1$ en parallèle à l'entrée du transistor $T_1$. En effet, la résistance $R_2$ est en série avec la résistance dynamique du petit transistor $T_3$ source de courant, dont la résistance est très élevée.

Le transistor $T_3$ source de courant doit être environ dix à vingt fois plus étroit que la largeur des transistors principal $T_1$ et secondaire $T_2$. Par conséquent, les dimensions de la source de courant constituée par $T_3$ est sans mesure commune avec les dimensions des selfs et lignes microbandes qui ont été analysées en figures 2 et 3. Si le courant nécessaire pour polariser le transistor $T_1$ aboutit à un transistor $T_3$ trop petit, inférieur à 5 microns, il est toujours possible d'augmenter la longueur de sa grille, car la fréquence de travail du transistor $T_3$ n'est pas primordiale comme la fréquence de travail du transistor principal $T_1$.

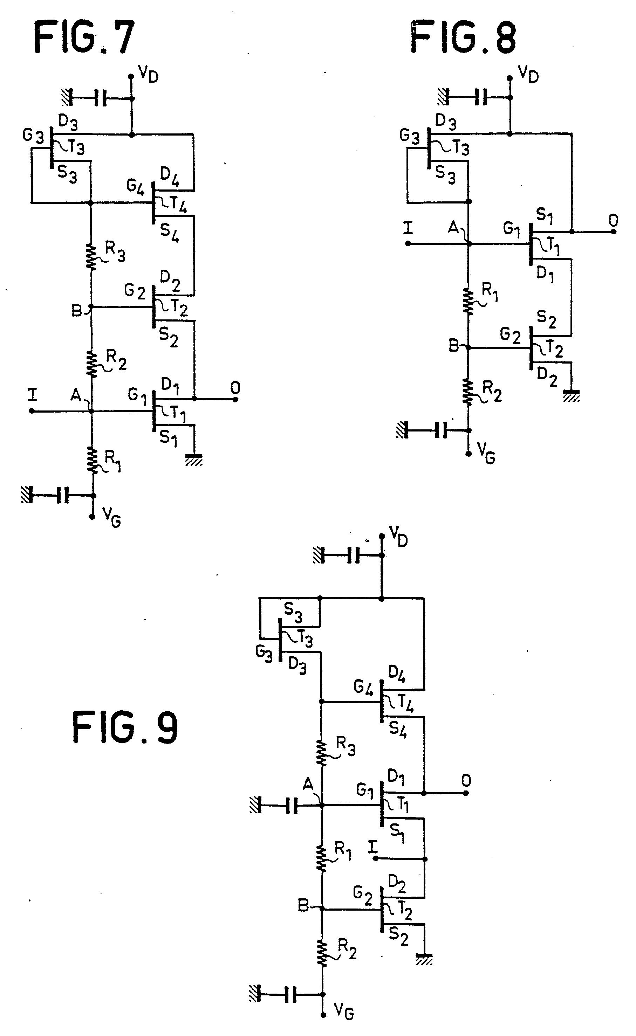

Il a été dit à l'occasion de la figure 5, que le transistor principal $T_1$ est quelquefois polarisé à travers une pluralité de transistors secondaires $T_2$ montés en charge saturable. La figure 7 représente une illustration de ce cas, dans le domaine de l'invention, c'est-à-dire que le transistor principal $T_1$ est polarisé à travers deux transistors secondaires $T_2$ et $T_4$ montés en charge saturable. Dans ce cas, le pont diviseur comporte autant de résistances $R_1$, $R_2$ et $R_3$ qu'il y a de transistors, y compris le transistor principal. Ainsi, si la figure 7 comportait un troisième transistor charge saturable, le pont diviseur comporterait une quatrième résistance.

Les figures 6 et 7 représentent le cas d'un transistor principal $T_1$ fonctionnant avec la source commune. La figure 8 représente le circuit de l'invention lorsque le transistor principal $T_1$ fonctionne en drain commun. Dans ce cas, la grille $G_1$ du transistor principal $T_1$ est toujours polarisée à travers un dispositif résistif, mais ce dispositif est dans le cas présent séparé en deux résistances $R_1$ et $R_2$ qui constituent le pont diviseur à partir duquel est polarisée la grille $G_2$ du transistor secondaire $T_2$ fonctionnant en charge saturable. Le transistor $T_3$ fonctionnant en source de courant est alimenté d'une part par la tension de polarisation de drain $V_D$ et est relié au pont diviseur $R_1$ et $R_2$. La tension grille-source $V_{G2S2}$ du transistor $T_2$ suit bien la tension grille-source $V_{G1S1}$ du transistor principal $T_1$ lorsque la tension de polarisation de grille $V_G$ varie.

Par rapport à la figure 6, la différence dans le cas de la figure 8 est que la résistance de polarisation de la grille $G_1$ du transistor $R_1$ n'est plus seulement la résistance $R_1$ mais est égale à la résistance $R_1 + R_2$.

En outre, ce circuit avec montage en drain commun peut être réalisé avec une pluralité de transistors secondaires $T_2$, $T_4$, ... etc., comme cela a été représenté en figure 7.

Dans le montage en drain commun de la figure 8, le circuit hyperfréquence extérieur au transistor principal $T_1$ « voit » à l'entrée du transistor la résistance $R_1 + R_2$ en parallèle avec la résistance dynamique du transistor source de courant $T_3$,

qui est très grande puisque le transistor $T_3$ est dix à vingt fois plus étroit que les transistors principal $T_1$ et secondaire $T_2$.

Enfin la figure 9 représente le montage du circuit de polarisation lorsque le transistor principal $T_1$ est monté en grille commune. Dans ce cas, les signaux hyperfréquences sont introduits dans le circuit du transistor principal $T_1$ par le point I sur sa source $S_1$ et en sortent sur le drain au point O. La grille $G_1$ est découplée à la masse par une capacité.

La grille $G_1$ du transistor principal $T_1$ est polarisée par une tension de polarisation de grille $V_G$ appliquée à travers un élément résistif constitué par les résistances $R_1$ et $R_2$. Celles-ci constituent le pont diviseur qui polarise la grille $G_2$ d'un transistor secondaire $T_2$ de polarisation de source du transistor principal $T_1$. Mais dans ce cas de figure, le pont diviseur comporte également une résistance $R_3$, montée en série avec un petit transistor $T_3$ source de courant, la résistance $R_3$ partie intégrante du pont diviseur, polarise la grille $G_4$ d'un second transistor secondaire $T_4$ qui polarise le drain du transistor principal $T_1$.

Le circuit de polarisation d'un transistor à effet de champ selon l'invention permet donc de polariser convenablement un transistor à effet de champ quel que soit son type de montage, en source commune, en drain commun ou grille commune. Il fait appel à un minimum de deux transistors, le premier fonctionnant en charge saturable polarise le drain du transistor principal tandis que le second fonctionnant en source de courant alimente un pont diviseur de tension. La présence de deux transistors supplémentaires n'est pas un inconvénient du point de vue de l'intégration en circuit intégré car ces transistors secondaires n'occupent pas plus de surface que le transistor principal. En outre, ce circuit permet de faire varier le point de polarisation du transistor principal donc d'optimiser les circuits dans lesquels ce transistor peut être utilisé, tel que des amplificateurs ou des déphaseurs hyperfréquences.

## Revendications

1. Circuit de polarisation d'un transistor à effet de champ $(T_1)$, fonctionnant dans le domaine des hyperfréquences, dont la grille $(G_1)$ est polarisée par une tension $(V_G)$ à travers une première résistance $(R_1)$, ce circuit étant caractérisé en ce que au moins une électrode d'accès $(D_1)$ du transistor principal $(T_1)$, par laquelle sort le signal hyperfréquence, est polarisée, à partir d'une source $(V_D)$ de tension, à travers un premier transistor secondaire $(T_2)$, à effet de champ, fonctionnant en charge saturable, dont la tension grille-source $(V_{G2S2})$ suit la tension de grille-source $(V_{G1S1})$ du transistor principal $(T_1)$, les grilles $(G_2$ et $G_1)$ de ces deux transistors $(T_2$ et $T_1)$ étant réunies en deux points (B et A respectivement) d'un pont diviseur constitué par au moins deux résistances $(R_1, R_2)$, alimenté à partir

des deux tensions de polarisation $(V_G, V_D)$ à travers un second transistor secondaire $(T_3)$ monté en source de courant.

2. Circuit de polarisation selon la revendication 1, caractérisé en ce que le transistor principal $(T_1)$ est monté en source commune, le signal hyperfréquence étant introduit (I) sur sa grille $(G_1)$ et recueilli (O) sur son drain $(D_1)$.

3. Circuit de polarisation selon la revendication 1, caractérisé en ce que l'électrode d'accès $(D_1)$ du transistor principal $(T_1)$ est polarisée à travers une pluralité de transistors secondaires $(T_2, T_4)$ montés en série, dont les grilles $(G_2, G_4)$ sont reliées à autant de résistances $(R_2, R_3)$ du pont diviseur.

4. Circuit de polarisation selon la revendication 1, caractérisé en ce que le point de polarisation du transistor principal $(T_1)$ est ajustable par variation de la tension de polarisation $(V_D)$ de l'électrode d'accès $(D_1)$.

5. Circuit de polarisation selon la revendication 1, caractérisé en ce que, le transistor principal $(T_1)$ étant monté en drain commun, la tension de polarisation $(V_D)$ est appliquée sur la source $(S_1)$ dudit transistor $(T_1)$, et le transistor secondaire $(T_2)$ fonctionnant en charge saturable est monté entre le drain $(D_1)$ du transistor principal $(T_1)$ et la masse.

6. Circuit de polarisation selon la revendication 1, caractérisé en ce que, le transistor principal $(T_1)$ étant monté en grille commune, une première électrode d'accès $(S_1)$ est polarisée à travers un premier transistor secondaire $(T_2)$ réuni à la masse, et une seconde électrode d'accès $(D_1)$ est polarisée à travers un second transistor secondaire $(T_4)$, réuni à la source de tension de polarisation $(V_D)$, les deux transistors secondaires $(T_2, T_4)$ ayant leurs grilles $(G_2, G_4)$ réunies en deux points du pont diviseur.

7. Circuit de polarisation selon l'une quelconque des revendications 1 à 6, caractérisé en ce qu'il est réalisé sous forme de circuit intégré.

## Claims

1. Polarising circuit of a field effect transistor $(T_1)$, operating in the hyperfrequency range, the gate $(G_1)$ of which is polarised by a voltage $(V_G)$ through a first resistor $R_1$), this circuit being characterized in that at least one access electrode $(D_1)$ of the main transistor $(T_1)$ which is the hyperfrequency signal output electrode is polarised from a voltage source $(V_D)$ through a first secondary field effect transistor $(T_2)$ operating at saturatable load and the gate-source voltage $(V_{G2S2})$ of which follows the gate-source voltage $(V_{G1S1})$ of the main transistor $(T_1)$, the gates $(G_2$ and $G_1)$ of these two transistors $(T_2$ and $T_1)$ being connected to two points (B and A, respectively) of a divider bridge formed by at least two resistors $(R_1, R_2)$ fed from two polarising voltages $(V_G, V_D)$ through a second secondary transistor $(T_3)$ mounted as a current source.

2. Polarising circuit according to claim 1, characterized in that the main transistor ($T_1$) is mounted in common source, the hyperfrequency signal being supplied (I) to its gate ($G_1$) and recoverd (O) on its drain ($D_1$).

3. Polarising circuit according to claim 1, characterized in that the access electrode ($D_1$) of the main transistor ($T_1$) is polarised through a plurality of secondary transistors ($T_2$, $T_4$) mounted in series and the gates ($G_2$, $G_4$) of which are connected to an equal number of resistors ($R_2$, $R_3$) of the divider bridge.

4. Polarising circuit according to claim 1, characterized in that the polarising point of the main transistor ($T_1$) is adjustable by varying the polarising voltage ($V_D$) of the access electrode ($D_1$).

5. Polarising circuit according to claim 1, characterized in that, the main transistor ($T_1$) being mounted in common drain, the polarising voltage ($V_D$) is applied to the source ($S_1$) of said transistor ($T_1$) and the secondary transistor ($T_2$) operating at saturatable load is mounted between the drain ($D_1$) of the main transistor ($T_1$) and ground.

6. Polarising circuit according to claim 1, characterized in that, the main transistor ($T_1$) being mounted in common gate, a first access electrode ($S_1$) is polarised through a first secondary transistor ($T_2$) connected to ground and a second access electrode ($D_1$) is polarised through a second secondary transistor ($T_4$) connected to the polarising voltage ($V_D$), the two secondary transistors ($T_2$, $T_4$) having their gates ($G_2$, $G_4$) connected to two points of the divider bridge.

7. Polarising circuit according to any of claims 1 to 6, characterized in that it is embodied as an integrated circuit.

**Patentansprüche**

1. Schaltung zur Polarisierung eines Feldeffekttransistors ($T_1$), der im Hyperfrequenzbereich arbeitet und dessen Gate ($G_1$) durch eine Spannung ($V_G$) über einen ersten Widerstand ($R_1$) polarisiert wird, wobei die Schaltung dadurch gekennzeichnet ist, daß mindestens eine Zugangselektrode ($D_1$) des Haupttransistors ($T_1$), über die das Hyperfrequenzsignal ausgegeben wird, durch eine Spannungsquelle ($V_D$) über einen Sekundärfeldeffekttransistor ($T_2$) polarisiert wird, der unter Last gesättigt betrieben wird und dessen Gate-Sourcespannung ($V_{G2S2}$) der Gate-Sourcespannung ($V_{G1S1}$) des Haupttransistors ($T_1$) folgt, wobei die Gates ($G_2$ und $G_1$) dieser beiden Transistoren ($T_2$ und $T_1$) in zwei Punkten (B bzw. A) mit einer Teilerbrücke verbunden sind, die aus mindestens zwei Widerständen ($R_1$, $R_2$) gebildet ist und die von zwei Polarisierungsspannungen ($V_G$, $V_D$) über einen zweiten Sekundärtransistor ($T_3$), der als Stromquelle geschaltet ist, versorgt wird.

2. Polarisierungsschaltung nach Anspruch 1, dadurch gekennzeichnet, daß der Haupttransistor ($T_1$) in Source-Schaltung geschaltet ist, wobei das Hyperfrequenzsignal über sein Gate ($G_1$) eingegeben (I) und über seinen Drain ($D_1$) ausgegeben (O) wird.

3. Polarisierungsschaltung nach Anspruch 1, dadurch gekennzeichnet, daß die Zugangselektrode ($D_1$) des Haupttransistors ($T_1$) über mehrere in Reihe geschaltete Sekundärtransistoren ($T_2$, $T_4$) polarisiert wird, deren Gates ($G_2$, $G_4$) mit derselben Anzahl von Widerständen ($R_2$, $R_3$) der Teilerbrücke verbunden sind.

4. Polarisierungsschaltung nach Anspruch 1, dadurch gekennzeichnet, daß der Polarisierungspunkt des Haupttransistors ($T_1$) durch Variation der Polarisierungsspannung ($V_D$) der Zugangselektrode ($D_1$) einstellbar ist.

5. Polarisierungsschaltung nach Anspruch 1, dadurch gekennzeichnet, daß der Haupttransistor ($T_1$) in Drain-Schaltung geschaltet ist und die Polarisierungsspannung ($V_D$) und die Source ($S_1$) dieses Transistors ($T_1$) angelegt wird und daß der unter Last gesättigt betriebene Sekundärtransistor ($T_2$) zwischen den Drain ($D_1$) des Haupttransistors ($T_1$) und die Masse geschaltet ist.

6. Polarisierungsschaltung nach Anspruch 1, dadurch gekennzeichnet, daß der Haupttransistor ($T_1$) in Gate-Schaltung geschaltet ist und eine erste Zugangselektrode ($S_1$) über einen ersten, mit der Masse verbundenen Sekundärtransistor ($T_2$) polarisiert wird und eine zweite Zugangselektrode ($D_1$) über einen zweiten Sekundärtransistor ($T_4$) polarisiert wird, der mit der Polarisierungsspannungsquelle ($V_D$) verbunden ist, wobei die beiden Sekundärtransistoren ($T_2$, $T_4$) mit ihren Gates ($G_2$, $G_4$) mit zwei Punkten der Teilerbrücke verbunden sind.

7. Polarisierungsschaltung nach einem der Ansprüche 1 bis 6, dadurch gekennzeichnet, daß er als integrierte Schaltung hergestellt wird.

# FIG.1

# FIG.2

# FIG.3

# FIG.4

# FIG.5

# FIG.6

# FIG.7

# FIG.8

# FIG.9